# FASCICULE DE BREVET EUROPEEN

(11) **EP 3 321 937 B1**
(45) Date de publication et mention de la délivrance du brevet: **04.09.2019**
(21) Numéro de dépôt: 17201907.7
(22) Date de dépôt: 15.11.2017
(51) Int. Cl.: G11B 33/12, G06F 1/18

(54) **SYSTÈME DE CONNEXION D'UNITÉ(S) DE SAUVEGARDE DE DONNÉES INFORMATIQUES**
SYSTEM ZUR VERBINDUNG VON SPEICHEREINHEITEN VON INFORMATIKDATEN
CONNECTION SYSTEM FOR COMPUTER DATA BACK-UP UNIT(S)

(30) Priorité: 15.11.2016 FR 1661056
(43) Date de publication de la demande: 16.05.2018
(73) Titulaire: Freebox, 75008 Paris (FR)
(72) Inventeur: CHARPIOT, Patrick, 92290 CHATENAY MALABRY (FR)
(74) Mandataire: Lavoix

(56) Documents cités:
- US-A1- 2012 147 545
- US-A1- 2013 167 368

## Description

La présente invention concerne un système de connexion d'unité(s) de sauvegarde de données informatiques à une carte mère informatique comprenant :
- un support pour différentes tailles d'unité(s) de sauvegarde de données informatiques, la ou les unité(s) de sauvegarde portant un connecteur, ou portant une superposition de plusieurs connecteurs,
- un connecteur multi-étages configuré pour être connecté à la carte mère et aux connecteur(s) d'unité(s) de sauvegarde, le connecteur multi-étages comprenant au moins deux étages de connexion superposés et solidarisés l'un à l'autre.

Par la suite par « unité de sauvegarde de données informatiques », on entend un matériel informatique configuré pour le stockage de données informatiques, tel qu'un seul disque dur ou un ensemble de disques durs DD, ou HD ou encore HDD (respectivement de l'anglais *Hard Disk* ou *Hard Disk Drive*), ou encore un seul disque ou un ensemble de disques comprenant une mémoire flash SSD (de l'anglais *Solid-State Drive*).

Deux tailles standard d'unité de sauvegarde de données informatiques sont actuellement utilisées à savoir 2,5 pouces et 3,5 pouces.

On connait différents types de système de connexion mâle-femelle d'unité(s) de sauvegarde de données.

Un exemple de système de connexion de deux unités de sauvegarde de 2,5 pouces superposées est décrit dans le document US 2011/0069441, et est basé sur un connecteur femelle comprenant deux connecteurs femelles identiques solidarisés en superposition sur un même plan de circuit imprimé (ou PCB de l'anglais *Printed Circuit Board*) placé perpendiculairement à la direction de connexion aux connecteurs mâles d'unité(s) de sauvegarde de données informatiques superposées.

Selon ce document, lors d'un changement de taille d'unité(s) de sauvegarde de données informatiques, ou de configuration de réception, à savoir avec ou sans superposition d'unité(s) de sauvegarde de données informatiques, il est nécessaire de démonter/remonter un connecteur femelle adapté à chaque configuration de réception.

Un tel démontage requiert en outre l'utilisation d'outils, de vis, de boulons ou encore de rivets pour solidariser/désolidariser le connecteur femelle au support d'unité(s) de sauvegarde.

D'autres exemples de système de connexion d'unité(s) de sauvegarde sont divulgués dans le document US 2013/167368 ou encore dans le document US 2012/147545, mais de même que dans le document US 2011/0069441, aucun de ces deux documents US 2013/167368 ou US 2012/147545 n'apporte de solution pour éviter, lors d'un changement de taille d'unité(s) de sauvegarde de données informatiques, un changement de connecteur impliquant un démontage/remontage.

Le but de l'invention est donc de proposer un système de connexion d'unité(s) de sauvegarde de données informatiques à une carte mère informatique indépendant de la taille d'unité(s) de sauvegarde de données ou de la mise en oeuvre ou non d'une superposition d'unité(s) de sauvegarde de données.

A cet effet, l'invention a pour objet un système de connexion d'unité(s) de sauvegarde de données informatiques à une carte mère informatique comprenant :
- un support pour différentes tailles d'unité(s) de sauvegarde de données informatiques, la ou les unité(s) de sauvegarde portant un connecteur, ou portant une superposition de plusieurs connecteurs,
- un connecteur multi-étages, configuré pour être connecté à la carte mère et aux connecteur(s) d'unité(s) de sauvegarde, le connecteur multi-étages comprenant au moins deux étages de connexion superposés et solidarisés l'un à l'autre,
dans lequel les au moins deux étages de connexion superposés du connecteur multi-étages, sont décalés l'un par rapport à l'autre selon le sens de connexion au(x) connecteur(s) d'unité(s) de sauvegarde de données informatiques portée(s) par le support.

Suivant d'autres aspects avantageux de l'invention, le système de connexion d'unité(s) de sauvegarde de données informatiques à une carte mère informatique comprend une ou plusieurs des caractéristiques suivantes, prises isolément ou suivant toutes les configurations techniquement possibles :
- selon le sens de connexion, un étage de connexion supérieur du connecteur multi-étages, est décalé, selon un décalage non nul, vers l'arrière par rapport à un étage de connexion inférieur ;
- le support comprend au moins un élément de décalage configuré pour décaler, vers l'arrière selon le sens de connexion, un connecteur supérieur par rapport à un connecteur inférieur d'unité(s) de sauvegarde de données informatiques, du décalage non nul associé aux étages de connexion correspondants du connecteur multi-étages ;
- le support comprend au moins un élément de positionnement d'unité(s) de sauvegarde dans le support, l'élément de positionnement d'unité(s) de sauvegarde étant configuré pour conserver une position de connexion permanente indépendamment de la taille d'unité(s) de sauvegarde ;
- un élément de décalage est localisé sur un élément de positionnement ;
- les au moins deux étages de connexion du connecteur multi-étages sont espacés par un étage d'espacement, selon la hauteur du connecteur multi-étages ;
- l'étage d'espacement du connecteur multi-étages comprend au moins une ouverture destinée à coopérer, selon le sens de connexion, avec un élément de guidage du support ;
- le connecteur multi-étages est formé d'une seule pièce
- le connecteur multi-étages comprend en outre au moins deux ports SATA associés respectivement aux au moins deux étages de connexion ;
- chaque connecteur comprend au moins une ligne d'alimentation électrique et au moins une ligne de communication de données.

Ces caractéristiques et avantages de l'invention apparaîtront plus clairement à la lecture de la description qui va suivre, donnée uniquement à titre d'exemple non limitatif, et faite en référence aux dessins annexés, sur lesquels :
- les figures 1 et 2 sont des vues en perspective, sous deux angles distincts, de deux configurations de réception d'un même support d'unité(s) de sauvegarde selon l'invention associées à deux tailles distinctes d'unité de stockage;
- la figure 3 est une vue de dessous d'un tel support d'unité(s) de sauvegarde,
- les figures 4 et 5 sont des vues en perspective, sous deux angles distincts de la pièce portant la paroi mobile,
- les figures 6 et 7 sont respectivement des vues en perspective, sous deux angles distincts, des deux configurations de réception du support illustrées sur les figures 1 et 2, avec unité(s) de sauvegarde.
- la figure 8 est une vue en perspective de l'assemblage d'un connecteur à l'unité de sauvegarde du support de la figure 7,
- la figure 9 est une vue en perspective du connecteur de la figure 8,
- la figure 10 est une vue en coupe de l'assemblage du connecteur aux unités de sauvegarde du support illustré par la figure 6.

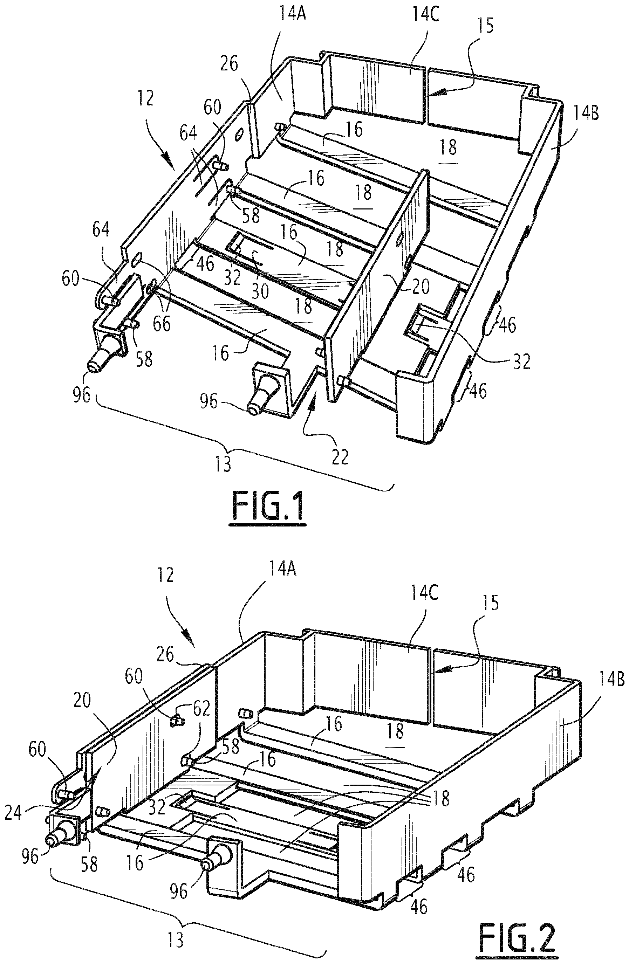

Sur la figure 1, le support 12 d'unité(s) de sauvegarde de données informatiques est rectangulaire. Le support 12 comprend, sur un côté, une ouverture 13 dédiée à la connexion d'unité(s) de sauvegarde. Sur les trois autres côtés, le support 12 est délimité par deux parois longitudinales 14A et 14B et une paroi transversale 14C. Ces trois parois 14A, 14B, 14C immobiles forment ensemble un cadre solidarisé perpendiculairement au fond du support 12.

Pour permettre une déformation manuelle du support 12 selon la largeur, la paroi transversale 14C est munie d'une fente 15.

Le fond du support 12 comprend une alternance de rails parallèles 16 de matériau constitutif du support 12 et d'ouvertures 18 s'étendant dans la largeur du support 12.

Le support 12 comprend également une paroi supplémentaire 20 s'étendant perpendiculairement par rapport au fond du support 12. La paroi 20 est parallèle aux deux parois longitudinales immobiles 14A et 14B du support 12.

Selon l'invention, la paroi supplémentaire 20 est mobile par rapport au fond du support 12. En particulier, la paroi mobile 20 est déplaçable, selon la largeur du support 12, le long d'un rail 16 à coulissement, entre deux positions extrêmes dans laquelle la paroi 20 est appliquée contre l'une ou l'autre des parois longitudinales 14A et 14B.

Sur la figure 1, la paroi mobile 20 est placée, par coulissement sur le fond du support 12 dans une position sortie 22 parallèlement à et entre les deux parois immobiles longitudinales 14A et 14B.

La position sortie 22 de la paroi mobile 20 correspond à une configuration de réception d'une première taille d'unité de sauvegarde de données informatiques par exemple de 2,5 pouces.

Sur la figure 2, la paroi mobile 20 est placée, par coulissement sur le fond du support 12 dans une position escamotée 24 contre la face interne d'une des parois immobiles 14A ou 14B s'étendant selon la longueur du support 12.

La position escamotée 24 de la paroi mobile 20 correspond à une configuration de réception d'une deuxième taille d'unité de sauvegarde de données informatiques, par exemple de 3,5 pouces, supérieure à la première taille associée à la position sortie 22.

La paroi immobile 14A, contre laquelle la paroi mobile 20 est placée est une ligne brisée présentant un décroché 26 configuré pour loger l'épaisseur de la paroi mobile 20 dans la position escamotée 24 telle qu'illustrée sur la figure 2.

Un tel support 12 présente, par exemple, une longueur comprise entre 130 et 200 mm (ou plus selon la profondeur de la baie d'ordinateur ou de serveur dans laquelle le support est destiné à être inséré) et une largeur comprise entre 100 mm et 120 mm. Les parois immobiles 14A, 14B, 14C présentent, par exemple une hauteur comprise entre 25 mm et 50 mm.

La paroi mobile supplémentaire 20 présente une hauteur égale, à plus ou moins 10% près, à la hauteur des parois immobiles 14A, 14B, 14C et une longueur inférieure aux longueurs des parois longitudinales 14A et 14B. La longueur de la paroi mobile 20 est par exemple, comprise entre 70 mm et 100 mm.

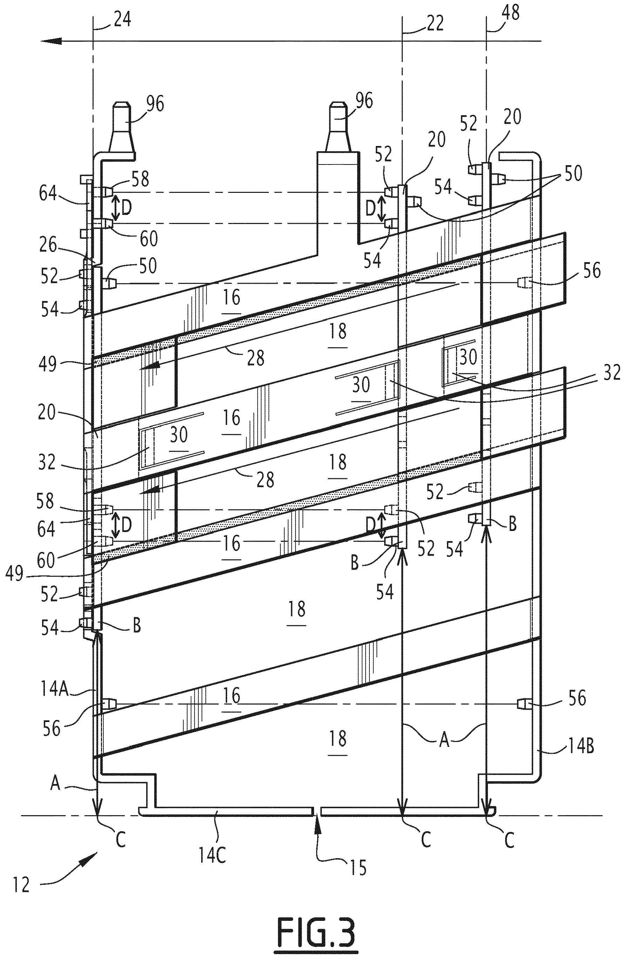

En relation avec la vue de dessous de la figure 3, les rails 16 et les ouvertures 18 sont parallèles et obliques aux parois parallèles immobiles 14A et 14B. En particulier, selon le sens de coulissement 28, où la paroi mobile 20 est propre à être déplacée de la position sortie 22 à la position escamotée 24, la distance A entre :
- l'extrémité B de la paroi mobile 20 la plus proche de la paroi transversale 14C, et
- le point C d'intersection entre la droite passant par la paroi mobile 20 et la droite perpendiculaire passant par la paroi transversale 14C,
   diminue.

Le rail 16 sur lequel la paroi mobile 20 se déplace en coulissement, comprend des éléments d'encliquetage 30 configurés chacun pour caler la paroi mobile 20 à l'une des positions sortie 22 ou escamotée 24.

Un élément d'encliquetage 30 de la paroi mobile 20, est constitué d'une lame élastique crantée, ménagée dans une fente du rail 16, au bout de laquelle est placé un cran d'arrêt 32.

Sur la figure 3, dans la position sortie 22, la largeur de réception comprise entre la paroi immobile 14A du support 12 et la paroi mobile 20, est supérieure de 1 à 2 mm à la largeur d'unité(s) de sauvegarde de données informatiques à placer, ce qui permet une liberté transversale (i.e. un jeu mécanique) de placement.

Pour favoriser la ventilation, la surface de matériau formant les rails 16 du fond du support 12 est inférieure à la surface des ouvertures 18.

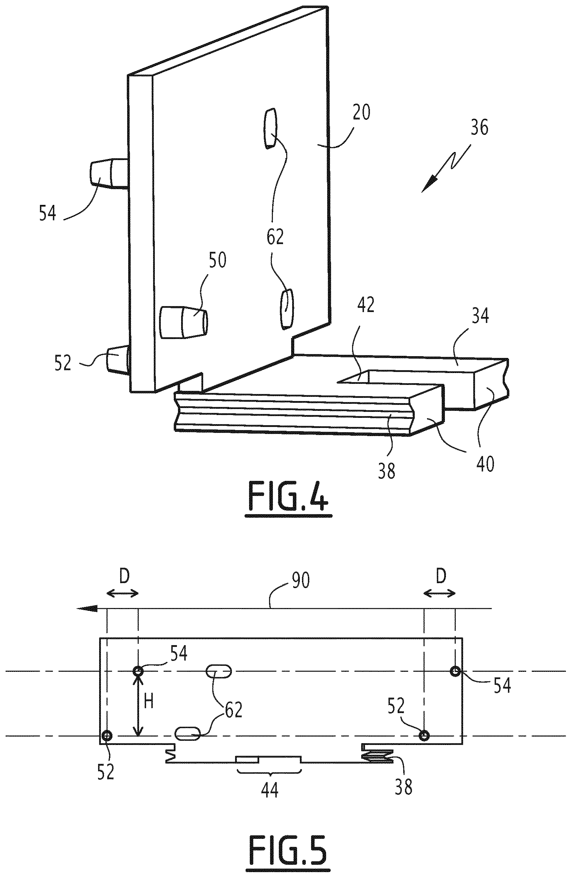

Sur la figure 4, la paroi mobile 20 est portée par une base 34 pour former un équipage mobile 36.

La base 34, en forme de U, s'étend, perpendiculairement à la paroi mobile 20, et à l'opposé de la paroi immobile 14A par rapport à la paroi mobile 20. En d'autres termes, l'équipage mobile 36 est en forme de L.

La base 34 présente deux rainures 38, ouvertes vers l'extérieur des extrémités libres des branches 40 du U, et coopérant avec les bords en regards de deux rails 16 non adjacents.

Dans sa partie médiane 42, la base 34 comporte une encoche inférieure 44 de passage du rail médian 16 présent entre les deux rails 16 sur lesquels coulisse l'équipage mobile 36.

L'équipage mobile 36 est amovible du support 12. La paroi 14B comporte des encoches 46 de passage des extrémités libres des branches 40 de la base 36 lorsque l'équipage mobile 36 est dans la position d'insertion 48 illustrée sur la figure 3.

Au voisinage de la paroi 14B, les rails 16 non adjacents ont des bords en retrait dépourvus de profil de guidage 49 permettant la mise en place de l'équipage mobile 36 entre les rails 16 dans la position d'insertion 48. Autrement dit, la longueur des profils de guidage 49 des rails 16 non adjacents est inférieure à la longueur des rails 16.

Sur la figure 4, la paroi mobile 20 comprend sur la face en regard de la paroi 14B un picot 50 de blocage, selon la hauteur du support 12, d'une unité de sauvegarde lorsque la paroi mobile 20 est dans la position escamotée 24.

Sur la figure 5, sur l'autre face en regard de la paroi 14B, la paroi mobile 20 comprend une ligne de deux picots inférieurs 52 et une ligne de deux picots supérieurs 54 de blocage, selon la hauteur du support 12, d'unités de sauvegarde superposées lorsque la paroi mobile 20 est dans la position sortie 22.

Ces picots inférieurs 52 et ces picots supérieurs 54 permettent d'éviter l'usage traditionnel de vis pour maintenir une unité de sauvegarde sur un support classique.

Sur la figure 3, l'angle aigu formé entre la direction des rails 16 et des ouvertures 18 obliques du support 12 et la perpendiculaire aux deux parois immobiles parallèles 14A et 14B est configuré pour aligner, perpendiculairement aux deux parois longitudinales parallèles 14A et 14B:
- les deux lignes de picots inférieurs 52 et supérieurs 54 de la paroi mobile 20 respectivement avec les deux lignes de picots inférieurs 58 et supérieurs 60 de la paroi 14A lorsque la paroi mobile 20 est dans la position de sortie 22, et
- le picot 50 de la paroi mobile 20 avec un picot 56 correspondant de la paroi 14B lorsque la paroi mobile 20 est dans la position escamotée 24.

Les picots 50, 52, 54, 56, 58, 60 sont propres à supporter, tels des taquets, la face inférieure d'une unité de sauvegarde, ou à être insérés, tel des goujons, transversalement dans des orifices (i.e. trous taraudés) dédiés placés sur les faces latérales et longitudinales des unités de sauvegarde de données informatiques.

Par ailleurs, la paroi mobile 20 comprend des lumières 62 pour le passage des picots 58 et 60 de la paroi 14A lorsque la paroi mobile 20 est dans la position escamotée 24. Réciproquement, la paroi immobile 14A comprend des lumières 66 pour le passage des picots 54 et 52 de la paroi mobile 20 en position escamotée 24.

Au moins un des picots 58, 60 de la paroi 14A, est escamotable ou porté par une lame déformable 64 intégrée à la paroi 14A.

Le support 12 est constitué d'un matériau, par exemple plastique, configuré pour se déformer en insérant/enlevant la ou les unité(s) de sauvegarde de données informatiques.

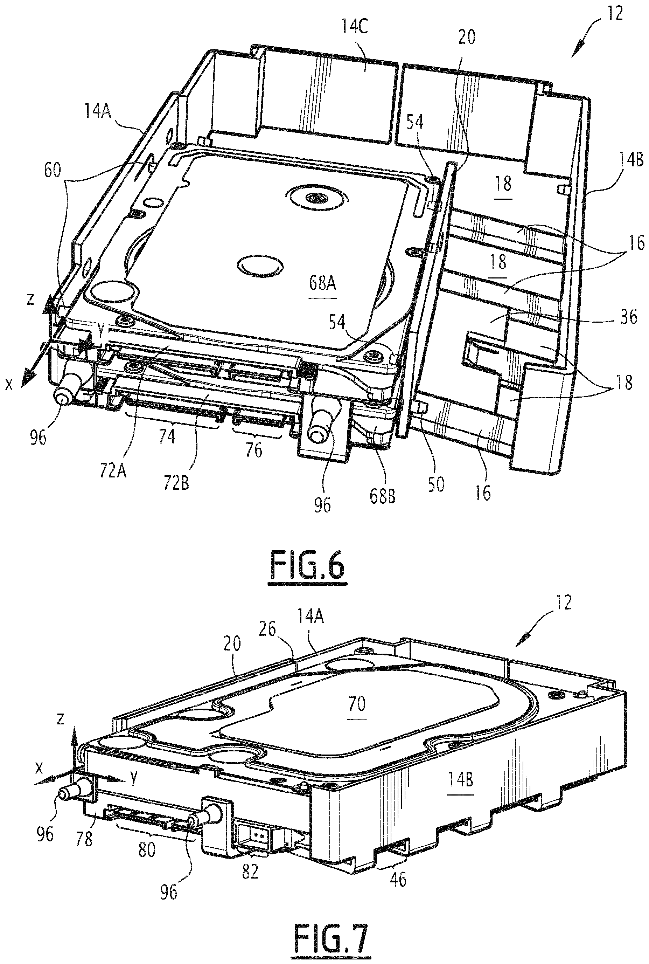

Sur la figure 6 deux unités 68A et 68B de sauvegarde de données de 2,5 pouces sont insérées en superposition dans le support 12 où la paroi mobile 20 est dans la position sortie 22.

Les deux unités 68A et 68B de sauvegarde de données de 2,5 pouces comprennent respectivement deux connecteurs mâles 72A et 72B dans l'ouverture 13 du support 12 illustrée sur les figures 1 et 2. Chaque connecteur mâle 72A ou 72B comprend au moins une ligne 74 de picots d'alimentation électrique et au moins une ligne 76 de picots de communication de données.

Sur la figure 7 une unité 70 de sauvegarde de données de 3,5 pouces est insérée dans le support 12 où la paroi mobile 20 est dans la position escamotée 24.

L'unité 70 de sauvegarde de données de 3,5 pouces comprend un connecteur mâle 78 dans l'ouverture 13 du support 12. Le connecteur mâle 78 comprend également au moins une ligne 80 de picots d'alimentation électrique et au moins une ligne 82 de picots de communication de données.

On constate que dans le repère (x, y, z) centré sur l'extrémité libre de la paroi 14B, la position du connecteur mâle inférieur 72B dans la position sortie 22 de la paroi mobile 20 et la position du connecteur mâle 78 dans la position escamotée 24 de la paroi mobile 20 sont identiques.

Autrement dit, la paroi mobile 20 est un élément de positionnement d'unité(s) de sauvegarde de données informatiques permettant, selon sa position, sortie 22 ou escamotée 24, de conserver une position de connexion permanente et indépendante de la taille d'unité(s) de sauvegarde de données informatiques.

Par ailleurs, il existe une dépendance entre la longueur des picots 58 et 60 de la paroi 14B, la longueur du picot 50 de la paroi mobile 20 et l'épaisseur de la paroi mobile 20.

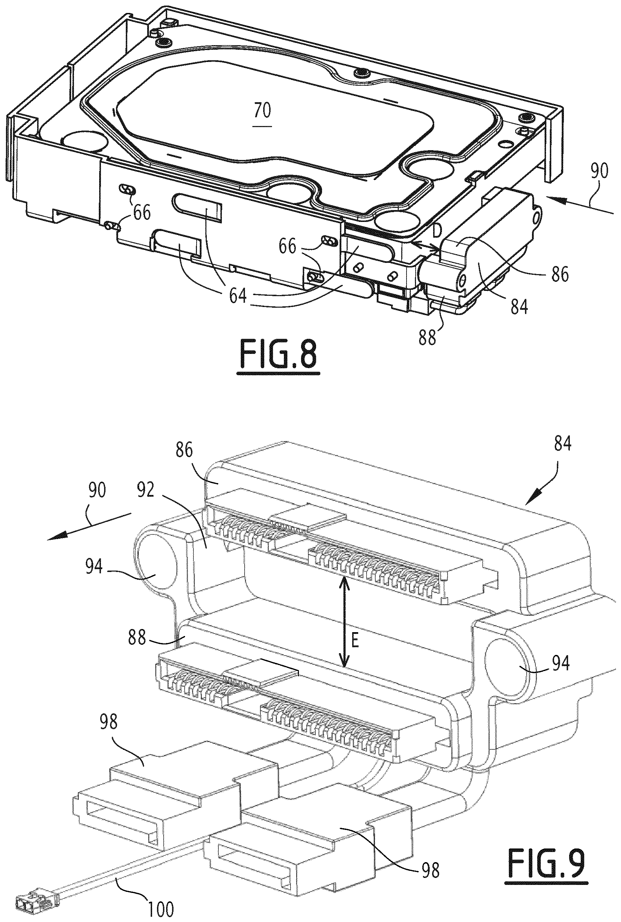

Sur la figure 8 un connecteur femelle 84 est assemblé au connecteur mâle 78 de l'unité de sauvegarde de données informatiques 70 du support 12 de la figure 7. Le connecteur femelle 84 est multi-étages et comprend deux étages 86 et 88 de connexion superposés et solidarisés l'un à l'autre, tels que représentés sur la figure 9. Un tel connecteur multi-étages 84 est par exemple solidarisé en fond de baie d'ordinateur ou de serveur.

Sur la figure 9, l'étage de connexion supérieur 86 du connecteur multi-étages 84 est décalé par rapport à l'étage 88 de connexion inférieur, selon un décalage D non nul, vers l'arrière par rapport au sens 90 de connexion du connecteur multi-étages 84 au(x) connecteur(s) 78 ou 72A et 72B d'unité(s) de sauvegarde de données informatiques portée(s) par le support 12.

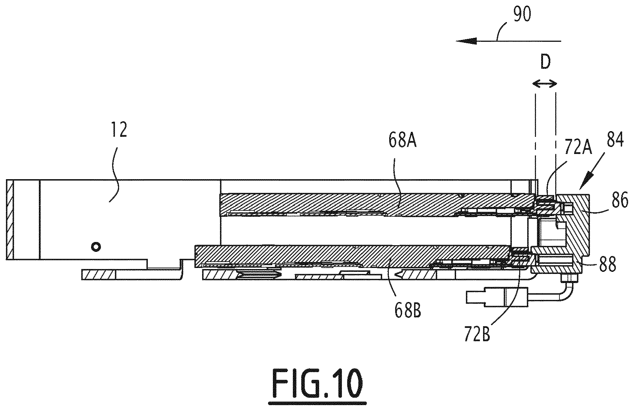

Réciproquement, sur la figure 10, le connecteur mâle supérieur 72A est décalé rapport au connecteur mâle inférieur 72B, selon le même décalage D non nul, vers l'arrière par rapport au sens 90 de connexion.

Les éléments de décalage du support 12 permettant un tel décalage D non nul selon le sens 90 de connexion des connecteurs mâles 72A et 72B d'unités 68A et 68B de sauvegarde superposées, sont d'une part les deux lignes de picots inférieurs 52 et supérieurs 54 portés par la paroi mobile 20 représentés sur les figures 3 et 5, et d'autre part les deux lignes de picots inférieurs 58 et supérieurs 60 portés la paroi 14B représentés sur la figure 3.

En d'autres termes, la position des picots inférieurs 52, 58 et supérieurs 54, 60 de décalage du support 12 est complémentaire, selon le sens 90 de connexion, de celle des étages de connexion inférieur 88, et supérieur 86 du connecteur multi-étages 84.

Le connecteur multi-étages 84 est formé d'une seule pièce, par exemple par surmoulage.

Par ailleurs, les au moins deux étages de connexion 86 et 88 sont espacés par un étage 92 d'espacement, selon la hauteur du connecteur multi-étages 84.

Pour favoriser la ventilation et permettre la réception de différentes épaisseurs d'unité(s) de sauvegarde de données informatiques, les deux lignes de picots inférieurs 52 et supérieurs 54 de la paroi mobile 20, et les deux lignes correspondantes de picots inférieurs 58 et supérieurs 60 de la paroi 14B sont espacées selon la hauteur d'une distance H supérieure à une épaisseur maximale d'unité(s) de sauvegarde de données informatiques.

Réciproquement, la hauteur E de l'étage 92 d'espacement du connecteur multi-étages 84 dépend de la distance H entre les lignes de picots du support 12.

Par ailleurs, l'étage 92 d'espacement du connecteur multi-étages 84 comprend au moins une ouverture 94 destinée à coopérer, selon le sens 90 de connexion avec un élément de guidage de connexion 96 du support 12.

Le connecteur multi-étages 84 comprend en outre au moins deux ports 98 SATA (de l'anglais *Serial Advanced Technology Attachment*) associés respectivement aux au moins deux étages 86 et 88 de connexion et relié à la carte mère d'ordinateur ou de serveur non représentée. Le connecteur multi-étages 84 comprend également un port 100 d'alimentation électrique.

On conçoit qu'avec un tel support 12 pour unité(s) de sauvegarde de données informatiques, le changement de taille d'unité(s) de sauvegarde est manuel, simple et rapide.

De plus, ce changement ne nécessite aucun outil ni pièce supplémentaire, et aucune partie du support 12 ou du connecteur multi-étages 84 n'entrave la bonne installation d'une unité de sauvegarde de données informatiques dans la configuration de réception sélectionnée par l'utilisateur.

## Revendications

1. Système de connexion d'unité(s) (68A, 68B, 70) de sauvegarde de données informatiques à une carte mère informatique comprenant :
- un support (12) pour différentes tailles d'unité(s) (68A, 68B, 70) de sauvegarde de données informatiques, la ou les unité(s) de sauvegarde portant un connecteur (72A, 72B, 78), ou portant une superposition de plusieurs connecteurs (72A, 72B, 78).
**caractérisé en ce qu'**il comprend:
- un connecteur multi-étages (84) configuré pour être connecté à la carte mère et au(x) connecteur(s) d'unité(s) de sauvegarde (68A, 68B, 70), le connecteur multi-étages (84) comprenant au moins deux étages (86, 88) de connexion superposés et solidarisés l'un à l'autre,
- les au moins deux étages (86, 88) de connexion superposés du connecteur multi-étages (84), sont décalés l'un par rapport à l'autre selon le sens (90) de connexion au(x) connecteur(s) (72A, 72B, 78) d'unité(s) de sauvegarde (68A, 68B, 70) de données informatiques portée(s) par le support (12).

2. Système de connexion d'unité(s) (68A, 68B, 70) de sauvegarde de données informatiques selon la revendication 1, dans lequel, selon le sens (90) de connexion, un étage de connexion supérieur (86) du connecteur multi-étages (84), est décalé, selon un décalage (D) non nul, vers l'arrière par rapport à un étage de connexion inférieur (88).

3. Système de connexion d'unité(s) (68A, 68B, 70) de sauvegarde de données informatiques selon la revendication 2, dans lequel le support comprend au moins un élément de décalage (52, 54, 58, 60) configuré pour décaler, vers l'arrière selon le sens (90) de connexion, un connecteur supérieur (72A) par rapport à un connecteur inférieur (72B) d'unité(s) de sauvegarde de données informatiques, du décalage (D) non nul associé aux étages (86, 88) de connexion correspondants du connecteur multi-étages (84).

4. Système de connexion d'unité(s) (68A, 68B, 70) de sauvegarde de données informatiques selon l'une quelconque des revendications précédentes, dans lequel le support (12) comprend au moins un élément de positionnement (20) d'unité(s) de sauvegarde (68A, 68B, 70) dans le support (12), l'élément de positionnement (20) d'unité(s) de sauvegarde étant configuré pour conserver une position de connexion permanente indépendamment de la taille d'unité(s) de sauvegarde (68A, 68B, 70).

5. Système de connexion d'unité(s) (68A, 68B, 70) de sauvegarde de données informatiques selon l'une quelconque des revendications 3 et 4, dans lequel un élément de décalage (52, 54) est localisé sur un élément de positionnement (20).

6. Système de connexion d'unité(s) de sauvegarde de données informatiques selon l'une quelconque des revendications précédentes, dans lequel les au moins deux étages (86, 88) de connexion du connecteur multi-étages (84) sont espacés par un étage d'espacement (92), selon la hauteur du connecteur multi-étages (84).

7. Système de connexion d'unité(s) (68A, 68B, 70) de sauvegarde de données informatiques selon la revendication 6, dans lequel l'étage d'espacement (92) du connecteur multi-étages (84) comprend au moins une ouverture (94) destinée à coopérer, selon le sens (90) de connexion, avec un élément de guidage (96) du support (12).

8. Système de connexion d'unité(s) de sauvegarde de données informatiques selon l'une quelconque des revendications précédentes, dans lequel le connecteur multi-étages (84) est formé d'une seule pièce.

9. Système de connexion d'unité(s) de sauvegarde de données informatiques selon l'une quelconque des revendications précédentes, dans lequel le connecteur multi-étages (84) comprend en outre au moins deux ports (98) SATA associés respectivement aux au moins deux étages de connexion.

10. Système de connexion d'unité(s) de sauvegarde de données informatiques selon l'une quelconque des revendications précédentes, dans lequel chaque connecteur (72A, 72B, 78) comprend au moins une ligne (74, 80) d'alimentation électrique et au moins une ligne (76, 82) de communication de données.

## Patentansprüche

1. System zur Verbindung einer/von Einheit/en (68A, 68B, 70) zum Schutz von Computerdaten mit einer Computer-Hauptplatine, aufweisend:
- einen Träger (12) für unterschiedliche Größen einer/von Einheit/en (68A, 68B, 70) zum Schutz von Computerdaten, wobei die Einheit/en zum Schutz ein Verbindungsteil (72A, 72B, 78) trägt/tragen oder eine Überlagerung von mehreren Verbindungsteilen (72A, 72B, 78) trägt/tragen,
**dadurch gekennzeichnet, dass** es aufweist
- ein Mehretagen-Verbindungsteil (84), das konfiguriert ist, um mit der Hauptplatine und dem/den Verbindungsteil/en der Einheit/en zum Schutz (68A, 68B, 70) verbunden zu sein, wobei das Mehretagen-Verbindungsteil (84) wenigstens zwei Etagen (86, 88) zur Verbindung aufweist, die einander überlagert und fest miteinander verbunden sind,
- wobei wenigstens zwei überlagerte Etagen (86, 88) zur Verbindung des Mehretagen-Verbindungsteils (84) zueinander im Abstand sind entlang der Richtung (90) des Verbindens mit dem/den Verbindungsteil/en (72A, 72B, 78) der Einheit(en) zum Schutz (68A, 68B, 70) von Computerdaten, die von dem Träger (12) getragen wird/werden.

2. System zur Verbindung einer/von Einheit/en (68A, 68B, 70) zum Schutz von Computerdaten gemäß Anspruch 1, wobei, entlang der Richtung (90) des Verbindens, eine obere Etage zur Verbindung (86) des Mehretagen-Verbindungsteils (84) um einen Versatz (D) ungleich null nach hinten versetzt ist bezüglich einer unteren Etage zur Verbindung (88).

3. System zur Verbindung einer/von Einheit/en (68A, 68B, 70) zum Schutz von Computerdaten gemäß Anspruch 2, wobei der Träger aufweist wenigstens ein Versetzelement (52, 54, 58, 60), das konfiguriert ist zum Versetzen, nach hinten entlang der Richtung (90) des Verbindens, eines oberen Verbindungsteils (72A) bezüglich eines unteren Verbindungsteils (72B) der Einheit/en zum Schutz von Computerdaten, um den Versatz (D) ungleich null, der den korrespondierenden Etagen (86, 88) zur Verbindung des Mehretagen-Verbinders (84) zugeordnet ist.

4. System zur Verbindung einer/von Einheit/en (68A, 68B, 70) zum Schutz von Computerdaten gemäß irgendeinem der vorhergehenden Ansprüche, wobei der Träger (12) aufweist wenigstens ein Element zur Positionierung (20) der Einheit/en zum Schutz (68A, 68B, 70) in dem Träger (12), wobei das Element zur Positionierung (20) der Einheit/en zum Schutz konfiguriert ist zum Erhalten einer permanenten Verbindungsposition unabhängig von der Größe der Einheit/en zum Schutz (68A, 68B, 70).

5. System zur Verbindung einer/von Einheit/en (68A, 68B, 70) zum Schutz von Computerdaten gemäß irgendeinem der Ansprüche 3 und 4, wobei das Versetzelement (52, 54) an dem Element zur Positionierung (20) angeordnet ist.

6. System zur Verbindung einer/von Einheit/en zum Schutz von Computerdaten gemäß irgendeinem der vorhergehenden Ansprüche, wobei die wenigstens zwei Etagen (86, 88) zur Verbindung des Mehretagen-Verbinders (84) entlang der Höhe des Multietagen-Verbinders (84) um eine Abstandsetage (92) im Abstand sind.

7. System zur Verbindung einer/von Einheit/en (68A, 68B, 70) zum Schutz von Computerdaten gemäß Anspruch 6, wobei die Abstandsetage (92) des Mehretagen-Verbinders (84) aufweist wenigstens eine Öffnung (94), die dazu bestimmt ist, entlang der Richtung (90) des Verbindens, mit einem Führungselement (96) des Trägers (12) zu kooperieren.

8. System zur Verbindung einer/von Einheit/en zum Schutz von Computerdaten gemäß irgendeinem der vorhergehenden Ansprüche, wobei der Mehretagen-Verbinder (84) aus einem einzigen Stück gemacht ist.

9. System zur Verbindung einer/von Einheit/en zum Schutz von Computerdaten gemäß irgendeinem der vorhergehenden Ansprüche, wobei der Mehretagen-Verbinder (84) ferner aufweist wenigstens zwei SATA Anschlüsse (98), die respektive wenigstens zwei Etagen zur Verbindung zugeordnet sind.

10. System zur Verbindung einer/von Einheit/en zum Schutz von Computerdaten gemäß irgendeinem der vorhergehenden Ansprüche, wobei jedes Verbindungsteil (72A, 72B, 78) wenigstens eine Leiste (74, 80) zur elektrischen Versorgung und wenigstens eine Leiste (76, 82) zur Datenkommunikation aufweist.

## Claims

1. Connection system for connecting computer data backup units (68A, 68B, 70) to a computer motherboard comprising:
- a support (12) for different sizes of computer data backup units (68A, 68B, 70), wherein the backup units carry a connector (72A, 72B, 78) or carry a superposition of a plurality of connectors (72A, 72B, 78),
**characterized in that it comprises** :
- a multi-stage connector (84) configured to be connected to the motherboard and to the backup unit connectors (68A, 68B, 70), wherein the multi-stage connector (84) comprises at least two connection stages (86, 88) superposed and fixed to one another,
- the at least two superposed connection stages (86, 88) of the multi-stage connector (84) are offset relative to each other according to the sense (90) of the connection(s) to the connector(s) (72A, 72B, 78) of the backup unit(s) (68A, 68B, 70) carried by the support (12).

2. Connection system for connecting computer data backup units (68A, 68B, 70) according to claim 1, wherein, according to the sense (90) of the connection 90), an upper connection stage (86) of the connector (84) is offset by a non-zero offset (D) towards the rear relative to a lower connection stage (88).

3. Connection system for connecting computer data backup units (68A, 68B, 70) according to claim 2, wherein the support comprises at least one offset element (52,54,58,60) configured to offset towards the rear an upper connector (72A) relative to a lower connector (72B) of the computer data backup units by the associated non-zero offset (D) with respect to the corresponding connection stages (86, 88) of the multi-stage connector (84).

4. Connection system for connecting computer data backup units (68A, 68B, 70) according to any one of the preceding claims, wherein the support (12) comprises at least one positioning element (20) of the back-up units (68A, 68B, 70) in the support (12), wherein the backup unit positioning element (20) is configured to maintain a permanent connection position irrespective of the size of the backup units (68A, 68B, 70).

5. Connection system for connecting computer data backup units (68A, 68B, 70) according to any one of the claims 3 and 4, wherein an offset element (52,54) is located on a positioning element (20).

6. Connection system for connecting computer data backup units according to any one of the preceding claims, wherein the at least two stages of connection (86, 88) of the multi-stage connector (84) are spaced apart by a spacing stage (92), along the height of the multi-stage connector (84).

7. Connection system for connecting computer data backup units (68A, 68B, 70) according to claim 6, wherein the spacing stage (92) of the multi-stage connector (84) comprises at least one opening (94) to interact with a guide element (96) of the support (12) according to the sense of the connection (90).

8. Connection system for connecting computer data backup units according to any one of the preceding claims, wherein the multi-stage connector (84) is formed in one piece.

9. Connection system for connecting computer data backup units according to any one of the preceding claims, wherein the multi-stage connector (84) further comprises at least two SATA ports (98) associated respectively with the at least two stages of connection.

10. Connection system for connecting computer data backup units according to any one of the preceding claims, wherein each connector (72A, 72B, 78) comprises at least one power supply line (74, 80) and at least one data communication line (76, 82).
